# EUROPÄISCHE PATENTANMELDUNG

(11) **EP 2 117 285 A1**
(43) Veröffentlichungstag der Anmeldung: **11.11.2009**
(21) Anmeldenummer: 09153481.8
(22) Anmeldetag: 24.02.2009
(51) Int. Cl.: H05K 1/18, H05K 1/16, H01F 27/26

(54) **Schaltungsträger zur Aufnahme eines Ferrit-Bauelements**

(30) Priorität: 29.04.2008 AT 6622008
(71) Anmelder: Siemens Aktiengesellschaft Österreich, 1210 Wien (AT)
(72) Erfinder: Ecker, Martin Ernst, 3542, Jaidhof (AT); Neuffer, Wolfgang, 1220, Wien (AT); Petricek, Martin, 2020, Hollabrunn (AT)
(74) Vertreter: Maier, Daniel Oliver

(57) **Zusammenfassung**

Die Erfindung betrifft einen Schaltungsträger (1) zur Aufnahme eines Ferrit-Bauelements (8), welches zumindest eine durchgehende Öffnung aufweist, wobei der Schaltungsträger (1) eine offene Kontur mit zumindest einer zungenförmigen Ausbildung (2) zur Durchführung durch die zumindest eine Öffnung des Ferrit-Bauelements (8) aufweist und wobei am offenen Ende der zungenförmigen Ausbildung (2) ein elektrischer Kontakt (4) angeordnet ist, welcher mit wenigsten einer auf der zungenförmigen Ausbildung (2) geführten Leiterbahn (3) verbunden ist. Des Weiteren bezieht sich die Erfindung auf eine Schaltungsanordnung mit einem derartigen Schaltungsträger (1) und einem Ferrit-Bauelement (8).

## Beschreibung

Die Erfindung betrifft einen Schaltungsträger zur Aufnahme eines Ferrit-Bauelements, welches zumindest eine durchgehende Öffnung aufweist. Des Weiteren bezieht sich die Erfindung auf eine Schaltungsanordnung, die einen derartigen Schaltungsträger und ein Ferrit-Bauelement umfasst, wobei ein Bereich des Schaltungsträgers durch die zumindest eine durchgehende Öffnung des Ferrit-Bauelements geführt ist.

Nach dem Stand der Technik kennt man verschiedene Möglichkeiten, ein Ferrit-Bauelement auf einem Schaltungsträger anzuordnen. Im einfachsten Fall wird das Ferrit-Bauelement auf dem Schaltungsträger aufgeklebt. Bei einem Ferrit-Bauelement mit zumindest einer durchgehenden Öffnung sind durch diese in der Regel Drähte geführt, deren Enden mit Kontaktstellen auf dem Schaltungsträger elektrisch leitend verbunden sind.

Eine andere Anordnung sieht vor, die durch eine Öffnung eines Ferrit-Bauelements geführten Leitungen als Leiterbahnen auf dem Schaltungsträger auszubilden. In diesem Fall weist der Schaltungsträger neben den Leiterbahnen Durchbrüche zur Aufnahme des Ferrit-Bauelements auf. Dabei ist das Ferrit-Bauelement zweiteilig mit einer Teilungsebene parallel zur Schaltungsträgerebene ausgebildet. Bei der Montage wird auf der Oberseite und auf der Unterseite des Schaltungsträgers jeweils ein Teil des Ferrit-Bauelements angeordnet, wobei die Teilungsflächen des Ferrit-Bauelements in den Durchbrüchen des Schaltungsträgers zusammentreffen.

Auf diese Weise werden die zwischen den Durchbrüchen des Schaltungsträgers geführten Leiterbahnen vom Ferrit-Bauelement umschlossen. Nach erfolgter Anordnung der Teile des Ferrit-Bauelements werden dessen Teilungsflächen in einem weiteren Montageschritt entweder zusammengeklebt oder mittels Klammern zusammengehalten.

Der Erfindung liegt die Aufgabe zugrunde, die aus dem Stand der Technik bekannten Anordnungen eines Ferrit-Bauelements auf einem Schaltungsträger weiterzubilden.

Erfindungsgemäß wird diese Aufgabe gelöst mit einem Schaltungsträger der eingangs genannten Art, wobei der Schaltungsträger eine offene Kontur mit zumindest einer zungenförmigen Ausbildung zur Durchführung durch die zumindest eine Öffnung des Ferrit-Bauelements aufweist und wobei am offenen Ende der zungenförmigen Ausbildung ein elektrischer Kontakt angeordnet ist, welcher mit wenigsten einer auf der zungenförmigen Ausbildung geführten Leiterbahn verbunden ist.

Die wenigstens eine auf der zungenförmigen Ausbildung angeordnete Leiterbahn ist im montierten Zustand durch die Öffnung des Ferrit-Bauelements geführt. Mittels des elektrischen Kontakts am offenen Ende der zungenförmigen Ausbildung ist die durch das Ferrit-Bauelement geführte Leitung mit weiteren Schaltungselementen kontaktierbar. Dabei können in einfacher Weise mehrere Leitungsschleifen durch das Ferrit-Bauelement geführt sein, indem auf der zungenförmigen Ausbildung mehrere Leiterbahnen angeordnet sind.

Der erfindungsgemäße Schaltungsträger hat den Vorteil, dass ein einteilig ausgeführtes oder ein bereits zusammengesetztes Ferrit-Bauelement in einfacher Weise auf dem Schaltungsträger montierbar ist. Dabei wird in einem Arbeitsschritt das Ferrit-Bauelement mit der Öffnung auf die zungenförmige Ausbildung der offenen Schaltungsträgerkontur aufgeschoben.

Eine Weiterbildung der Erfindung sieht vor, dass die offene Kontur des Schaltungsträgers neben der zumindest einen zungenförmigen Ausbildung eine im Wesentlichen stabförmige Ausbildung aufweist, sodass zwischen der zungenförmigen Ausbildung und der stabförmigen Ausbildung ein Schlitz zur Aufnahme eines Bereichs des Ferrit-Bauelements vorhanden ist. Die stabförmige Ausbildung ist dabei in eine von der zungenförmigen Ausbildung wegweisenden Richtung elastisch verformbar.

Ein auf die zungenförmige Ausbildung des Schaltungsträgers aufgeschobenes Ferrit-Bauelement ist dabei so dimensioniert, dass die stabförmige Ausbildung zur Seite gedrückt wird. Die auf dieser Weise vorgespannte stabförmige Ausbildung hält dann mit einer entsprechenden Haltekraft das Ferrit-Bauelement in Position.

Ferrit-Bauelemente weisen in der Regel große Fertigungstoleranzen auf. Deshalb ist es vorteilhaft, wenn das offene Ende der stabförmigen Ausbildung an der der zungenförmigen Ausbildung zugewandten Seite eine Fase aufweist. Damit wird das Aufschieben eines Ferrit-Bauelements erleichtert.

Des Weiteren ist es von Vorteil, wenn das offene Ende der stabförmigen Ausbildung an der der zungenförmigen Ausbildung zugewandten Seite einen nasenförmigen Fortsatz aufweist. Die Kontaktstelle zwischen einem Ferrit-Bauelement und der vorgespannten stabförmigen Ausbildung ist dann unabhängig von den Fertigungstoleranzen des Ferrit-Bauelements immer durch den nasenförmigen Fortsatz bestimmt. Auf diese Weise lässt sich die auf das Ferrit-Bauelement wirkende Haltekraft in einfacher Weise festlegen.

Über die beschriebenen Merkmale des Schaltungsträgers hinausgehend bezieht sich die Erfindung auch auf eine Schaltungsanordnung, einen Schaltungsträger und ein Ferrit-Bauelement umfassend, wobei ein Bereich des Schaltungsträgers durch zumindest eine durchgehende Öffnung des Ferrit-Bauelements geführt ist. Der Schaltungsträger weist dabei eine der oben beschriebenen Ausprägungen auf, wobei die zumindest eine zungenförmige Ausbildung der offenen Schaltungsträgerkontur durch die zumindest eine durchgehende Öffnung des Ferrit-Bauelements geführt ist. Eine derartige Schaltungsanordnung erlaubt eine einfache Montage eines Ferrit-Bauelements.

Dabei ist es vorteilhaft, wenn die offene Kontur des Schaltungsträgers neben der zumindest einen zungenförmigen Ausbildung eine im Wesentlichen stabförmige Ausbildung aufweist und wenn ein Bereich des Ferrit-Bauelements in der Weise im Spalt zwischen der zungenförmigen Ausbildung und der stabförmigen Ausbildung angeordnet ist, dass das Ferrit-Bauelement durch die Krafteinwirkung der elastisch verformten stabförmigen Ausbildung in Position gehalten ist. Das auf diese Weise mit dem Schaltungsträger verbundene Ferrit-Bauelement behält unabhängig von den Fertigungstoleranzen seine Position bei. Das ist beispielsweise beim innerbetrieblichen Transport während der Fertigung von Bedeutung, wenn noch keine Kontaktbrücke am offenen Ende der zungenförmigen Ausbildung montiert ist.

Eine Kontaktierung des offenen Endes der zumindest einen zungenförmigen Ausbildung erflogt günstigerweise durch einlöten oder einpressen in eine durchkontaktierte oder einseitig kaschierte Bohrung eines weiteren Schaltungsträgers.

In einer Ausprägung der Erfindung ist das Ferrit-Bauelement als E-I-Kern ausgebildet, wobei jeweils eine zungenförmige Ausbildung des Schaltungsträgers mit zumindest einer darauf geführten Leiterbahn und einem Kontakt am offenen Ende durch die beiden durchgehenden Öffnungen des E-I-Kerns geführt ist.

Günstigerweise sind dabei die beiden Kontakte an den Enden der beiden zungenförmigen Ausbildungen mittels einer Kontaktbrücke elektrisch leitend verbunden. Auf diese Weise wird eine Leitung mit einer oder mehreren Windungen durch die beiden Öffnungen des E-I-Kerns geführt.

Als günstige Kontaktbrücke ist ein weiterer Schaltungsträger mit einer die beiden Kontakte verbindenden Leiterbahn vorgesehen.

Die Erfindung wird nachfolgend in beispielhafter Weise unter Bezugnahme auf die beigefügten Figuren erläutert. Es zeigen in schematischer Darstellung:
- Fig. 1: Schaltungsträger mit zwei zungenförmigen Ausbildungen
- Fig. 2: Schaltungsanordnung mit einem Ferrit-Bauelement in einer Aufsicht
- Fig. 3: Schaltungsanordnung mit einem Ferrit-Bauelement in einer Schrägsicht

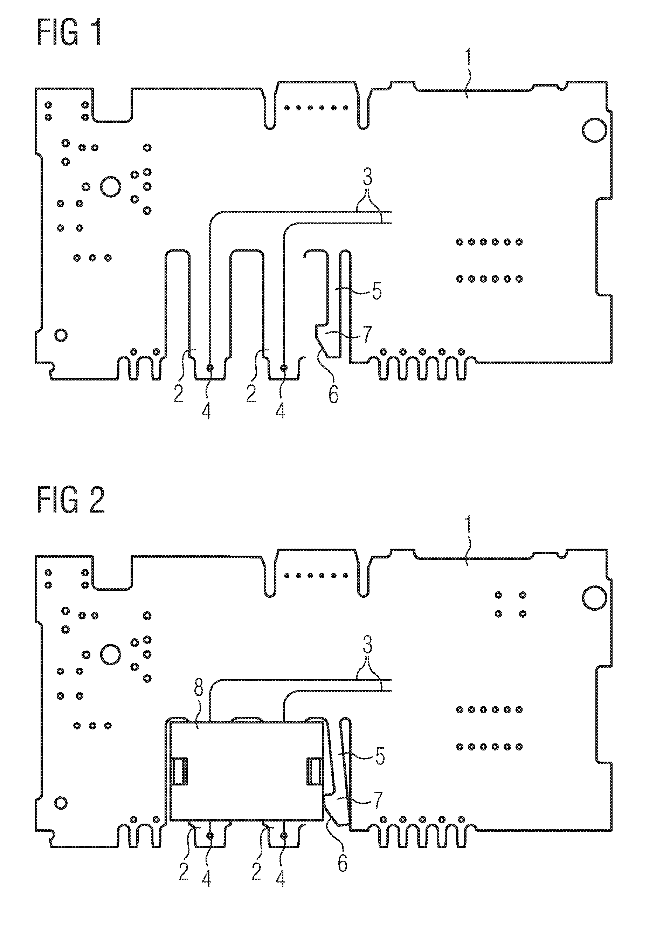

Der in Fig. 1 dargestellte Schaltungsträger 1 ist zum Aufschieben eines Ferrit-Bauelements 8 mit zwei durchgehenden Öffnungen, zum Beispiel eines E-I-Kerns, ausgebildet.
Dementsprechend sind auf der offenen Kontur des Schaltungsträgers 1 zwei nebeneinander liegende zungenförmige Ausbildungen 2 ausgeformt.

In einer einfacheren Ausprägung weist der Schaltungsträger 1 nur eine zungenförmige Ausbildung 2 auf, beispielsweise zum Aufschieben einer als Ferrithülse ausgebildeten Ferrit-Bauelements 8.

Jede zungenförmige Ausbildung 2 weist am offenen Ende einen elektrischen Kontakt 4 auf, der mit einer auf der zungenförmigen Ausbildung 2 geführten Leiterbahn 3 verbunden ist. Dabei können auch mehrere Leiterbahnen parallel auf einer zungenförmigen Ausbildung angeordnet sein.

Der Übersichtlichkeit halber sind die Leiterbahnen 3 nur im Bereich der zungenförmigen Ausbildungen 2 eingezeichnet. Der weiterführende Verlauf und andere auf dem Schaltungsträger angeordneten Leiterbahnen und Schaltungselemente sind nicht dargestellt. Die auf den zungenförmigen Ausbildungen 2 verlaufenden Leiterbahnen 3 können beispielsweise mit Kontakten am Rand des Schaltungsträgers 1, mit auf dem Schaltungsträger 1 angeordneten Schaltungselementen oder miteinander zur Bildung einer geschlossen Schleife verbunden sein.

Bei der Bestückung des Schaltungsträgers 1 wird ein Ferrit-Bauelement 8 in einem Stück mit den durchgehenden Öffnungen über die zungenförmigen Ausbildungen 2 geschoben. Um ein aufgeschobenes Ferrit-Bauelement 8 in Position zu halten, ist vorteilhafterweise neben einer zungenförmiger Ausbildung 2 eine schmälere stabförmige Ausbildung 5 ausgeformt. Aufgrund der Elastizität des Schaltungsträgermaterials wirkt diese stabförmige Ausbildung 5 als federnde Halteeinrichtung. Dabei wird die stabförmige Ausbildung 5 beim Aufschieben des Ferrit-Bauelements 8 elastisch verformt, indem des Ferrit-Bauelement 8 mit einer Innenfläche einer Öffnung über eine im Wesentlichen starre zungenförmige Ausbildung 2 gleitet und dabei mit einer Außenfläche die stabförmige Ausbildung 5 in eine von der zungenförmigen Ausbildung 2 wegweisende Richtung drückt.

Die auf diese Weise vorgespannte stabförmige Ausbildung 5 übt im montierten Zustand eine Kraft auf das Ferrit-Bauelement 8 aus, wobei Reibungskräfte aufgrund entsprechender Reibungskoeffizienten an den Kontaktstellen ein Abgleiten des Ferrit-Bauelements 8 verhindern. Das Ferrit-Bauelement 8 wird also mittels einer reibschlüssigen Verbindung in Position gehalten.

In einer andern, nicht dargestellten Ausführung weist das Ferrit-Bauelement 8 eine Einkerbung auf, in der ein Fortsatz der vorgespannten stabförmigen Ausbildung 5 eingerastet ist. Eine derartige formschlüssige Verbindung erhöht die Sicherheit gegen ein Abgleiten des Ferrit-Bauelements 8 aus der vorgesehen Position.

Die Geometrie der zungenförmigen Ausbildungen 2 und der stabförmigen Ausbildung 5 hängt von der Form des Ferrit-Bauelements 8 und von dessen in der Regel großen Fertigungstoleranzen ab. Dabei ist auf eine ausreichende Freistellung der stabförmigen Ausbildung 5 zu achten, damit der Federweg an der Kontaktstelle mit einem Ferrit-Bauelement 8 den zu erwartenden Toleranzbereich abdeckt.

Die stabförmige Ausbildung 5 ist zum einfacheren Aufschieben eines Ferrit-Bauelements 8 am offenen Ende mit einer Fase 6 ausgebildet. Zudem ist eine Hinterschneidung auf der der zungenförmigen Ausbildung 2 zugewandten Seite vorgesehen, sodass am offenen Ende ein nasenförmiger Fortsatz 7 ausgebildet ist.

Fig. 2 zeigt eine Schaltungsanordnung mit dem in Fig. 1 dargestellten Schaltungsträger und einem als E-I-Kern ausgebildeten Ferrit-Bauelement 8. Die stabförmige Ausbildung 5 ist elastisch verformt und drückt mit dem nasenförmigen Fortsatz 7 gegen das Ferrit-Bauelement 8.

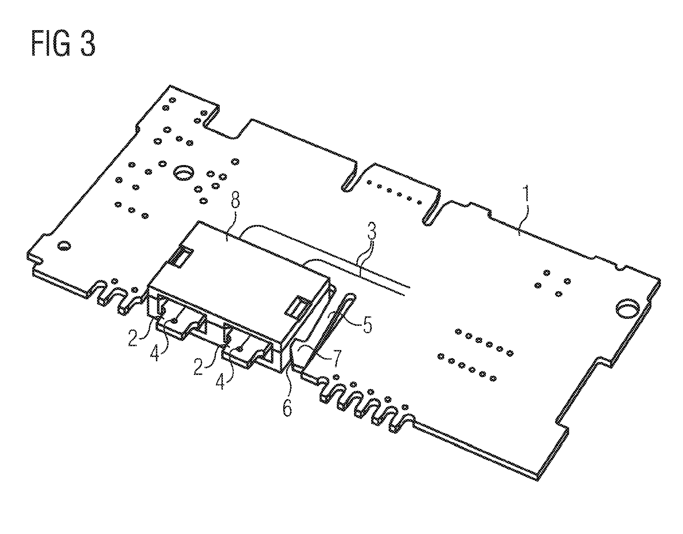

Dieselbe Anordnung ist in Fig. 3 in einer Schrägansicht dargestellt. Dabei sind die beiden Öffnungen des E-I-Kerns sichtbar, durch die die beiden zungenförmigen Ausbildungen 2 des Schaltungsträgers 1 geführt sind. Auf den aus den Öffnungen ragenden Enden der zungenförmigen Ausbildung 2 sind die elektrischen Kontakte 4 platziert, mittels derer die durch das Ferrit-Bauelement 8 geführten Leiterbahnen 3 an eine weiterführende Schaltung anschließbar sind.

Beispielsweise wird die Seite der Schaltungsträgerkontur, an der das Ferrit-Bauelement 8 angeordnet ist, senkrecht auf einen weiteren Schaltungsträger aufgesetzt. Die Leiterbahnen 3 durch das Ferrit-Bauelement 8 sind dann über die elektrischen Kontakte 4 mit Schaltungselementen auf diesem weitern Schaltungsträger kontaktierbar. Dabei ist es vorteilhaft, wenn die zungenförmigen Ausbildungen 2 länger als die stabförmige Ausbildung 5 sind, damit die Enden der zungenförmigen Ausbildungen 2 durch entsprechende Bohrungen des weiteren Schaltungsträgers reichen und die stabförmige Ausbildung 5 nicht auf der Oberfläche des weiteren Schaltungsträgers ansteht.

In einer anderen Ausprägung werden die elektrischen Kontakte 4 an den Enden der zungenförmigen Ausbildungen 2 mittels einfacher Kontaktbrücken miteinander oder mit anderen Kontaktstellen des Schaltungsträgers 1 verbunden.

## Patentansprüche

1. Schaltungsträger (1) zur Aufnahme eines Ferrit-Bauelements (8), welches zumindest eine durchgehende Öffnung aufweist, **dadurch gekennzeichnet, dass** der Schaltungsträger (1) eine offene Kontur mit zumindest einer zungenförmigen Ausbildung (2) zur Durchführung durch die zumindest eine Öffnung des Ferrit-Bauelements (8) aufweist und dass am offenen Ende der zungenförmigen Ausbildung (2) ein elektrischer Kontakt (4) angeordnet ist, welcher mit wenigsten einer auf der zungenförmigen Ausbildung (2) geführten Leiterbahn (3) verbunden ist.

2. Schaltungsträger (1) nach Anspruch 1, **dadurch gekennzeichnet, dass** die offene Kontur des Schaltungsträgers (1) neben der zumindest einen zungenförmigen Ausbildung (2) eine im Wesentlichen stabförmige Ausbildung (5) aufweist, sodass zwischen der zungenförmigen Ausbildung (2) und der stabförmigen Ausbildung (5) ein Schlitz zur Aufnahme eines Bereichs des Ferrit-Bauelements (8) vorhanden ist und dass die stabförmige Ausbildung (5) in eine von der zungenförmigen Ausbildung (2) wegweisenden Richtung elastisch verformbar ist.

3. Schaltungsträger nach Anspruch 2, **dadurch gekennzeichnet, dass** das offene Ende der stabförmigen Ausbildung (5) an der der zungenförmigen Ausbildung (2) zugewandten Seite eine Fase (6) aufweist.

4. Schaltungsträger nach Anspruch 2 oder 3, **dadurch gekennzeichnet, dass** das offene Ende der stabförmigen Ausbildung (5) an der der zungenförmigen Ausbildung (2) zugewandten Seite einen nasenförmigen Fortsatz (7) aufweist.

5. Schaltungsanordnung, einen Schaltungsträger (1) und ein Ferrit-Bauelement (8) umfassend, wobei ein Bereich des Schaltungsträgers (1) durch zumindest eine durchgehende Öffnung des Ferrit-Bauelements (8) geführt ist, **dadurch gekennzeichnet, dass** der Schaltungsträger (1) nach einem der Ansprüche 1 bis 4 ausgeführt ist und die zumindest eine zungenförmige Ausbildung (2) der offenen Schaltungsträgerkontur durch die zumindest eine durchgehende Öffnung des Ferrit-Bauelements (8) geführt ist.

6. Schaltungsanordnung nach Anspruch 5, **dadurch gekennzeichnet, dass** die offene Kontur des Schaltungsträgers (1) neben der zumindest einen zungenförmigen Ausbildung (2) eine im Wesentlichen stabförmige Ausbildung (5) aufweist und dass ein Bereich des Ferrit-Bauelements (8) in der Weise im Spalt zwischen der zungenförmigen Ausbildung (2) und der stabförmigen Ausbildung (5) angeordnet ist, dass das Ferrit-Bauelement (8) durch die Krafteinwirkung der elastisch verformten stabförmigen Ausbildung (5) in Position gehalten ist.

7. Schaltungsanordnung nach Anspruch 5 oder 6, **dadurch gekennzeichnet, dass** das offene Ende der zumindest einen zungenförmigen Ausbildung (2) in eine durchkontaktierte oder einseitig kaschierte Bohrung in einem weiteren Schaltungsträger eingelötet oder eingepresst ist.

8. Schaltungsanordnung nach Anspruch 5 oder 6, **dadurch gekennzeichnet, dass** das Ferrit-Bauelement (8) als E-I-Kern ausgebildet ist und dass jeweils eine zungenförmige Ausbildung (2) mit zumindest einer darauf geführten Leiterbahn (3) und einem Kontakt (4) am offenen Ende durch die beiden durchgehenden Öffnungen des E-I-Kerns geführt ist.

9. Schaltungsanordnung nach Anspruch 8, **dadurch gekennzeichnet, dass** die offene Kontur des Schaltungsträgers (1) neben den beiden zungenförmigen Ausbildungen (2) eine im Wesentlichen stabförmige Ausbildung (5) aufweist, welche elastisch verformt ist und den E-I-Kern in Position hält.

10. Schaltungsanordnung nach Anspruch 9, **dadurch gekennzeichnet, dass** die beiden Kontakte (4) an den Enden der beiden zungenförmigen Ausbildungen (2) mittels einer Kontaktbrücke elektrisch leitend verbunden sind.

11. Schaltungsanordnung nach Anspruch 10, **dadurch gekennzeichnet, dass** die Kontaktbrücke als weiterer Schaltungsträger mit einer die beiden Kontakte (4) verbindenden Leiterbahn ausgebildet ist.
